# EUROPEAN PATENT APPLICATION

(11) **EP 4 497 856 A1**
(43) Date of publication of application: **29.01.2025**
(21) Application number: 24190219.6
(22) Date of filing: 23.07.2024
(51) Int. Cl.: C30B 29/36, G01B 15/08, G06T 7/00

(54) **SIC INGOT AND METHOD FOR MANUFACTURING SIC INGOT**

(30) Priority: 24.07.2023 JP 2023120078; 24.10.2023 JP 2023182652
(71) Applicant: Resonac Corporation, Tokyo 105-7325 (JP)
(72) Inventor: SUO, Hiromasa, Tokyo, 105-7325 (JP)
(74) Representative: Strehl Schübel-Hopf & Partner

(57) **Abstract**

A SiC ingot according to the present embodiment has been identified a value of a basal plane dislocation density obtained by directly measuring at least one of a Si-face, a C-face, and a side-face.

## Description

### BACKGROUND

### Field

The present disclosure relates to a SiC ingot and a method for manufacturing a SiC ingot.

Silicon carbide (SiC) has a dielectric breakdown field that is one order of magnitude larger than that of silicon (Si) and a band gap that is three times larger than that of silicon (Si). In addition, silicon carbide (SiC) has characteristics such as a thermal conductivity that is about three times higher than that of silicon (Si). Therefore, silicon carbide (SiC) is expected to be applied to power devices, high-frequency devices, and high-temperature operation devices. For this reason, SiC epitaxial wafers have recently been used as substrates for the above-described semiconductor devices.

SiC epitaxial wafer is obtained by stacking SiC epitaxial layer on the surface of a SiC substrate. Hereafter, a substrate before stacking SiC epitaxial layer is called a SiC substrate, and a substrate after stacking SiC epitaxial layer is called a SiC epitaxial wafer. SiC substrates are manufactured by cutting from a SiC ingot. SiC devices such as power devices, high-frequency devices, and high-temperature operation devices are obtained by chipping the SiC epitaxial wafer after forming devices on SiC epitaxial layer of the SiC epitaxial wafer.

Basal plane dislocation (BPD) is known as one of device killer defects in SiC epitaxial wafer that cause critical defects in SiC devices. For example, when currents are applied in the forward direction of a bipolar device, the recombination energy of the carriers causes partial dislocations of the basal plane dislocations inherited from a SiC substrate by SiC epitaxial layer to migrate and expand, forming high resistance stacking defects. This high resistance area in the device causes a decrease in device reliability (forward degradation).

Basal plane dislocations in the SiC epitaxial layer are often inherited from basal plane dislocations in the SiC substrate. Thus, for example, Patent Documents 1 and 2 disclose methods for evaluating basal plane dislocations in SiC substrate. Patent Document 1 discloses a use of a correlation between X-ray topographic image contrast and basal plane dislocations to evaluate in-plane distribution of basal plane dislocations in the SiC substrate. Patent Document 2 discloses that basal plane dislocations are classified from X-ray topographic images of each defect and basal plane dislocation densities of SiC single crystal substrate are measured.

### [Patent Documents]

[Patent Document 1]
   Japanese Patent No. 6197722
[Patent Document 2]
   Japanese Patent No. 6037673

### SUMMARY

A SiC ingot manufacturing process is upstream from a SiC substrate manufacturing process. There has been a demand for evaluation of basal plane dislocations at the SiC ingot stage. However, it is difficult to evaluate SiC ingots directly. For example, when a basal plane dislocation density of a SiC ingot is measured through the method described in Patent Document 1, it is difficult to accurately measure basal plane dislocations because diffraction intensity varies for reasons other than the basal plane dislocations. This is because SiC ingots are thicker than SiC substrates. When using X-ray topography to evaluate thick SiC ingots, it is necessary to use reflection X-ray topographic images. However, the signal intensity of reflection X-rays varies greatly due to effects such as variations in X-ray penetration length. When measuring a basal plane dislocation density from an X-ray topographic image, the basal plane dislocation density is measured based on a correlation between the X-ray intensity and the basal plane dislocation density. In this case, the basal plane dislocation density cannot be accurately measured if the signal intensity of the reflection X-rays varies.

Therefore, a part of a SiC ingot is cut out as an evaluation substrate, and an X-ray topographic image of the evaluation substrate is measured. However, in this case, the measurement target is the evaluation substrate, which is not reliable in terms of quality assurance of the entire SiC ingot. In addition, when evaluation substrates are cut out, the portion of the SiC ingot that can be used for products is reduced, which is problematic in that product yield is reduced.

The present disclosure has been made in consideration of the above-described problems, and an object of the present disclosure is to provide a SiC ingot and a method for manufacturing a SiC ingot which are likely to guarantee quality and have high yield.

The present inventors have conducted extensive studies, and as a result, they have found that a basal plane dislocation density can be measured even for a SiC ingot by extracting a correlation between a basal plane dislocation density and an image of the entire measurement region, instead of using only intensity of an X-ray topographic image. Even if intensities of X-ray topographic images vary, morphologys of the images of the entire measurement region remain unchanged, allowing measurement of the basal plane dislocation density.
(1) A SiC ingot according to a first aspect has been identified a value of a basal plane dislocation density obtained by directly measuring at least one of a Si-face, a C-face, and a side-face.
(2) In the SiC ingot according to the above-described aspect, the value of the basal plane dislocation density may be an output value determined from entire-plane measurement results of at least one of the Si-face and the C-face.
(3) In the SiC ingot according to the above-described aspect, the value of the basal plane dislocation density may be an output value determined from a measurement value of the side-face or a measurement value of the side-face and a measurement value of a plane other than the side-face.
(4) In the SiC ingot according to the above-described aspect, the value of the basal plane dislocation density may be a value determined from a correspondence table which is obtained through a preliminary study and represents a correlation between the basal plane dislocation density and a reflection X-ray topographic image of at least one of the Si-face, the C-face, and the side-face.
(5) In the SiC ingot according to the above-described aspect, the value of the basal plane dislocation density may be an estimation value estimated from a reflection X-ray topographic image of at least one of the Si-face, the C-face, and the side-face based on learning results of deep learning.
(6) A method for manufacturing a SiC ingot according to a second aspect, including: a measurement step of directly measuring at least one of a Si-face, a C-face, and a side-face of a SiC ingot; and an evaluation step of determining a basal plane dislocation density of the SiC ingot based on a correlation between measurement results of the measurement step and the basal plane dislocation density.
(7) In the method for manufacturing a SiC ingot according to the above-described aspect, in the measurement step, at least one of the Si-face and the C-face may be measured.
(8) In the method for manufacturing a SiC ingot according to the above-described aspect, in the measurement step, at least the side-face may be measured.
(9) In the method for manufacturing a SiC ingot according to the above-described aspect, in the measurement step, a reflection X-ray topographic image may be measured.
(10) In the method for manufacturing a SiC ingot according to the above-described aspect, in the evaluation step, the basal plane dislocation density of the SiC ingot may be estimated based on learning results of deep learning.

The SiC ingot according to the above-described aspect has a high accuracy of quality assurance.

### BRIEF DESCRIPTION OF THE DRAWINGS

FIG. 1 is a perspective view of a SiC ingot according to the present embodiment.
FIG. 2 is an explanatory view of a measurement tool for measuring the SiC ingot according to the present embodiment.

### DETAILED DESCRIPTION

Hereinafter, a SiC ingot and a method for manufacturing a SiC ingot according to the present embodiment will be described in detail with reference to the drawing as appropriate. In the drawings used in the following description, a part that becomes a feature of the present embodiment is sometimes enlarged for convenience in order to allow the feature to be easily understood, and the dimensional ratios of each constituent element and the like are sometimes different from the actual ones. The materials, dimensions, and the like exemplified in the following description are merely examples, and the present disclosure is not limited thereto and can be implemented by being appropriately modified within the range that does not change the gist thereof.

In the present specification, individual orientations and collective orientations are indicated by [] and <>, respectively. For negative indices, crystallography requires a sign "-" (bar) to be placed above numbers, but in the present specification, numbers are preceded by the negative sign.

### "SiC Ingot"

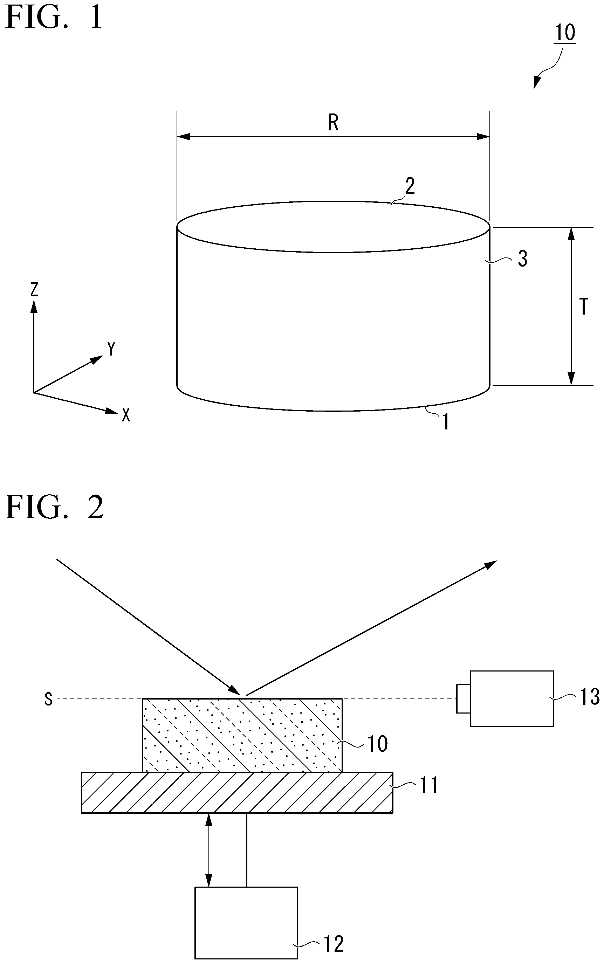

FIG. 1 is a perspective view of a SiC ingot 10 according to the present embodiment. The SiC ingot 10 is a cylindrical SiC single crystal. The SiC ingot 10 is processed into a cylindrical shape so that a SiC substrate can be cut out.

The diameter R of the SiC ingot 10 is, for example, 145 mm or more, preferably 149 mm or more, more preferably 155 mm or less, and still more preferably 151 mm or less. The diameter R of the SiC ingot 10 is, for example, 195 mm or more, preferably 199 mm or more, more preferably 205 mm or less, and still more preferably 201 mm or less. From the SiC ingot 10, for example, 6-inch substrates may be obtained or 8-inch substrates may be obtained.

The thickness T of the SiC ingot 10 is, for example, 10 mm or more, preferably 20 mm or more, more preferably 30 mm or more, and still more preferably 40 mm or more. The thicker the SiC ingot 10 is, the more SiC substrates can be obtained.

The SiC ingot 10 has, for example, a Si-face 1, a C-face 2, and a side-face 3. The Si-face 1 is the (0001) plane of the SiC ingot 10, where the surface atoms are Si atoms. The C-face 2 is the (000-1) plane of the SiC ingot 10, where the surface atoms are C atoms. The side-face 3 is a plane which connects the Si-face 1 to the C-face 2 and is cylindrical. The Si-face 1 and the C-face 2 of the SiC ingot 10 may have an offset angle in the <11-20> direction. For example, the Si-face 1 and the C-face 2 may have an offset angle of 0.1 degrees to 8 degrees in the <11-20> direction and no offset angle in the <1-100> direction. The offset angle of the SiC ingot 10 is not limited to this example.

The Si-face 1 is, for example, mirror-polished, mechanically polished, or Chemical Mechanical Polishing (CMP). The surface roughness (Ra) of the Si-face 1 is, for example, 5 nm or less. It is required for the measurement plane of an X-ray topographic image to be a mirror plane. If the Si-face 1 is a mirror plane, an X-ray topographic image of the Si-face 1 can be measured.

The C-face 2 is, for example, mirror-polished, mechanically polished, or Chemical Mechanical Polishing (CMP). The surface roughness (Ra) of the C-face 2 is, for example, 5 nm or less. If the C-face 2 is a mirror plane, an X-ray topographic image of the C-face 2 can be measured.

In addition, the side-face 3 is, for example, mirror-polished. The surface roughness (Ra) of the side-face 3 is, for example, 5 nm or less. The surface roughness (Ra) of the side-face 3 is measured at the same position in the circumferential direction in the Z direction. If the side-face 3 is a mirror plane, an X-ray topographic image of the side-face 3 can be measured. In addition, only some regions of the side-face 3, including at least the measurement region, may be mirror-polished. In this case, the side-face 3 includes portions where the surface roughness (Ra) is 5 nm or less. Although the details will be described below, only a predetermined range of the side-face 3 may be measured. In this case, it is sufficient if a predetermined range thereof is a mirror plane. The entire plane of the side-face 3 may be a mirror plane, and the surface roughness (Ra) of the entire plane thereof may be 5 nm or less.

The SiC ingot 10 has been identified a value of a basal plane dislocation density. The "value" is an average basal plane dislocation density within a predetermined region. The value of a basal plane dislocation density is identified as information that guarantees the quality of the SiC ingot 10. For example, the value of a basal plane dislocation density is maintained with the SiC ingot 10 as an inspection sheet or a certificate of analysis. The inspection sheet or the certificate of analysis may be actual documents or date. The basal plane dislocation density is obtained by dividing the number of basal plane dislocations by the area of a region. For example, if the measurement plane is the Si-face 1, it is the average basal plane dislocation density of the entire Si-face 1. For example, if the measurement plane is the C-face 2, it is the average basal plane dislocation density of the entire C-face 2. For example, if the measurement plane is the side-face 3, it is the average basal plane dislocation density of the measurement region of the side-face 3.

A value of a basal plane dislocation density of the SiC ingot 10 is obtained using direct measurement results of at least one of the Si-face 1, the C-face 2, and the side-face 3. The SiC ingot 10 has a high accuracy of quality assurance because the SiC ingot 10 itself is directly evaluated instead of measuring evaluation substrates cut out from the SiC ingot. The quality of the SiC ingot 10 is guaranteed by handling a set of the SiC ingot 10 and the inspection sheet or the certificate of analysis (for example, data with a quality assurance value attached). A person in charge of post-processing of the SiC ingot 10 checks the quality of the SiC ingot data set. The SiC ingot data set has, for example, the SiC ingot 10 and the data including the value of the basal plane dislocation density of the SiC ingot 10.

The value of the basal plane dislocation density is an output value (estimation value) estimated from direct measurement results of at least one of the Si-face 1, the C-face 2, and the side-face 3. The value of the basal plane dislocation density may be an output value (estimation value) estimated from a direct measurement result of the Si-face 1, an output value (estimation value) estimated from a direct measurement result of the C-face 2, an output value (estimation value) estimated from a direct measurement result of the side-face 3, an output value (estimation value) estimated from direct measurement results of the Si-face 1 and the C-face 2, an output value (estimation value) estimated from direct measurement results of the Si-face 1 and the side-face 3, an output value (estimation value) estimated from direct measurement results of the C-face 2 and the side-face 3, or an output value (estimation value) estimated from direct measurement results of the Si-face 1, the C-face 2, and the side-face 3.

First, a method for obtaining measurement values will be described. When obtaining measurement values, a preliminary step, a measurement step, and an evaluation step are performed.

In the preliminary step, a correspondence table showing a correlation between an X-ray topographic image of a SiC ingot and a basal plane dislocation density of the SiC ingot is created. The SiC ingot to be evaluated here is a different SiC ingot from the SiC ingot to be measured. In the preliminary step, the correlation between the X-ray topographic image and the basal plane dislocation density of the SiC ingot is derived from a plurality of pieces of data, and a correspondence table is created.

In the preliminary step, evaluation substrates are cut out from the SiC ingot, and the basal plane dislocation density of the SiC ingot is evaluated using the evaluation substrates. The preliminary step is a step for making a correspondence table. Therefore, to improve the accuracy of the correspondence table, the preliminary step may take time and there may be some loss of the SiC ingot. Once the correspondence table is maked, no preliminary step may be required for subsequent evaluation of the SiC ingot.

The X-ray topographic image to be measured in the preliminary step is an entire image of a macroscopic measurement plane. For example, when measuring the Si-face 1, the X-ray topographic image is an entire image of the Si-face 1. For example, when measuring the C-face 2, the X-ray topographic image is an entire image of the C-face 2. For example, when measuring the side-face 3, the X-ray topographic image is an entire image of the set measurement region. The measurement region may be a whole circumference in the circumferential direction of the side-face 3, a region with a specific width in the circumferential direction of the side-face 3, or a region in an arbitrarily set predetermined range. By using a macroscopic entire image rather than a local image of a defective portion, an estimation processing in an estimation step does not require evaluation of local images, and the time required for estimating a basal plane dislocation density can be reduced.

In addition, the X-ray topographic image to be measured in the preliminary step is an entire image instead of intensity distribution of the X-ray topographic image. The entire X-ray topographic image includes information on overall strain as well as dislocations. The intensity distribution of the X-ray topographic image may have variations in signal intensity due to effects such as variations in X-ray penetration length measurement. The effects of variations in X-ray penetration length is small for the evaluation substrates to be measured in the preliminary step because the evaluation substrates are thin, but the effects are large for the SiC ingot to be measured in the measurement step. Therefore, when only the intensity distribution of the X-ray topographic image is used, a correlation between the basal plane dislocation density and the intensity distribution of the X-ray topographic image obtained in the preliminary measurement often does not match a correlation between a basal plane dislocation density and intensity distribution of an X-ray topographic image of a SiC ingot. In contrast, the entire X-ray topographic image is a measurement of the surface pattern and is less susceptible to variations in penetration length, unlike a case where intensity distribution is set to an evaluation target.

The X-ray topographic image to be measured in the preliminary step may be a diffraction image containing a diffraction vector in the <11-20> direction or a diffraction image containing a diffraction vector in the <1-100> direction.

The number of basal plane dislocations in SiC substrates to be measured in the preliminary step may be determined from X-ray topographic images, by a photoluminescence method, using a mirror electron microscope, or by measuring etch pits after KOH etching. In the preliminary step, to improve the accuracy of the correspondence table, it is preferable to evaluate etch pits after KOH etching to classify basal plane dislocations.

To improve the accuracy of the correspondence table, the number of SiC ingots to be evaluated in the preliminary step is preferably sufficiently large. For example, it is preferable to measure a relationship between basal plane dislocation densities and X-ray topographic images of 100 or more SiC ingots.

In addition, deep learning may be used for making the correspondence table. The data collected in the preliminary step correspond to teacher data for deep learning. The teacher data may be stored, for example, in a memory of an evaluation device or on a server located outside the evaluation device. A learning program uses deep learning to learn the correlation between the basal plane dislocation densities and the X-ray topographic images of the respective SiC ingots.

The X-ray topographic images stored as the teacher data may be taken as they are or may be compressed. For example, images compressed to a pixel size of 0.1 mm² or larger may be stored as teacher data. The pixel size represents a size of one pixel. For example, an image obtained by compressing an X-ray topographic image taken to 250×250 pixels may be used as teacher data.

The greater the number of teacher data, the higher the accuracy of estimation of a basal plane dislocation density. The number of teacher data showing the relationship between the basal plane dislocation densities and the X-ray topographic images is preferably 100 or more. If a sufficient number of SiC ingots cannot be prepared, an inverted or rotated image of an X-ray topographic image of a single SiC ingot may be used as part of the teacher data. For example, a combination of an X-ray topographic image of an evaluation substrate cut from a first SiC ingot and a basal plane dislocation density of the evaluation substrate may be used as first data, a combination of an inverted image of the X-ray topographic image of the evaluation substrate and the basal plane dislocation density of the evaluation substrate may be used as second data, and a combination of a rotated image of the X-ray topographic image of the evaluation substrate and the basal plane dislocation density of the evaluation substrate may be used as third data.

The respective diameters of the plurality of SiC ingots to be measured in the preliminary step may not necessarily coincide with each other. For example, the plurality of SiC ingots to be measured in the preliminary step may include both a substrate with a diameter of 6 inches and a substrate with a diameter of 8 inches.

By performing the preliminary step as described above, a correspondence table showing the correlation between the basal plane dislocation densities and the X-ray topographic images of the SiC ingots can be obtained. The preliminary step is preferably performed through deep learning. Deep learning enables efficient processing of large amounts of data.

Next, in the measurement step, an X-ray topographic image of a SiC ingot is obtained. The X-ray topographic image to be measured here is also an entire image of a macroscopic measurement plane. If a correspondence table in the preliminary step is created based on measurement results of the Si-face 1, the measurement plane to be measured in the measurement step is the Si-face 1. Similarly, when correspondence tables are created using the C-face 2 and the side-face 3, the same planes as those measured when creating their correspondence tables are measured. A plane for which an X-ray topographic image of a SiC ingot is acquired in the measurement step may be only the Si-face 1, may be only the C-face 2, may be only the side-face 3, may be the Si-face 1 and the C-face 2, may be the Si-face 1 and the side-face 3, or may be all of the Si-face 1, the C-face 2, and the side-face 3. In the measurement step, at least one of the Si-face 1 and the C-face 2 or at least the side-face 3 is preferably measured. The image to be measured is preferably a reflection X-ray topographic image. Reflection X-ray topographic images have information on surfaces of measurement planes and are less likely to have noise than transmission X-ray topographic images which change with the depth of X-ray penetration.

The basal plane dislocation density of a SiC ingot to be actually evaluated is preferably 10,000/cm² or less, more preferably 5,000/cm² or less, still more preferably 2,500/cm² or less, still more preferably 1,000/cm² or less, and particularly preferably 500/cm² or less. If the basal plane dislocation density is too low, it is difficult to measure the basal plane dislocation density from intensity of an X-ray topographic image. This is because without basal plane dislocations, there is no shading in the X-ray signal intensity, making it more susceptible to noise. When estimating a basal plane dislocation density from an entire X-ray topographic image, the basal plane dislocation density can be estimated even if the basal plane dislocation density is low.

The actual diameter R of a SiC ingot to be evaluated may be the same as or different from the diameters of the SiC substrates measured in the preliminary step. For example, the actual diameter of the SiC ingot to be evaluated may be larger than the diameters of the SiC ingots measured in the preliminary step. If the actual diameter of the SiC ingot to be evaluated is the same as the diameters of the SiC ingots measured in the preliminary step, the evaluation accuracy will increase.

In the measurement step, a predetermined plane of the SiC ingot 10 is directly measured through, for example, X-ray topography. The plane to be measured in the measurement step may be only the Si-face 1, may be only the C-face 2, may be only the side-face 3, may be the Si-face 1 and the C-face 2, may be the Si-face 1 and the side-face 3, or may be all of the Si-face 1, the C-face 2, and the side-face 3. In the measurement step, at least one of the Si-face 1 and the C-face 2 or the side-face 3 is preferably measured. Here, since SiC ingots 10 have shape variations from sample to sample, direct measurement of the SiC ingots 10 is performed using a specified measurement tool.

FIG. 2 is an explanatory view of a measurement tool for measuring a SiC ingot. The measurement tool has a support 11 that supports the SiC ingot 10, a driving mechanism 12 that changes the height position of the support 11, and a measurement mechanism 13 that measures the height position of a measurement plane S. The SiC ingot 10 has a different thickness from sample to sample. In addition, even within the SiC ingot 10, there is a large variation in flatness. The measurement tool can be used to position the measurement plane S for each measurement or during measurement. The driving mechanism 12 moves the support 11 in the vertical direction to position the measurement plane S of the SiC ingot 10. The measurement mechanism 13 checks the position of the measurement plane S. The measurement mechanism 13 is, for example, a camera.

For example, when X-ray topography is used in the measurement step, a measurement tool for measuring a SiC ingot can be used to emit X-rays at appropriate positions from appropriate angles. To use the correlation maked in the preliminary step, it is important that the X-ray irradiation angle to the SiC ingot 10 does not vary. In addition, when X-ray topography is used in the measurement step, reflection X-ray topography is preferably used. Thick SiC ingots are difficult to measure through transmission X-ray topography because X-rays do not penetrate them or, even if they do, the signal is weak.

For example, when measuring basal plane dislocations of the Si-face 1, the entire Si-face image is acquired. When measuring a basal plane dislocation density of the C-face 2, the entire C-face image is acquired. When measuring a basal plane dislocation density of the side-face 3, a measurement region is first set. The measurement region may be a whole circumference in the circumferential direction of the side-face 3, a region with a specific width in the circumferential direction of the side-face 3, or a region in an arbitrarily set predetermined range. Then, the entire image of the entire plane of this measurement region is acquired.

An X-ray topographic image to be measured in the measurement step may be a diffraction image containing a diffraction vector in the <1 1-20> direction or a diffraction image containing a diffraction vector in the <1-100> direction. The X-ray topographic image to be measured in the measurement step is set to a diffraction image containing a diffraction vector in the same direction as the X-ray topographic image measured in the preliminary step.

If compressed X-ray topographic images are stored as teacher data in the preliminary step, the measured X-ray topographic images may be compressed. For example, X-ray topographic images are compressed so that they have a pixel size of 0.1 mm² or larger. If the diameters of the SiC ingots measured in the preliminary step are different from the actual diameter of the SiC ingot to be evaluated, the X-ray topographic images obtained by measuring each SiC ingot are compressed to the same size (for example, 250×250 pixels).

The resolution of each X-ray topographic image is reduced by performing image compression. Image compression allows operations in the estimation step to be performed based on low-resolution images, reducing computational loads on an evaluation device.

Subsequently, the evaluation step is performed. In the evaluation step, a basal plane dislocation density is estimated from an X-ray topographic image to be measured in the measurement step based on the correspondence table. When deep learning is used, the X-ray topographic image of the entire measurement plane of a SiC ingot is used as input, and a basal plane dislocation density at a position corresponding to the measurement plane of the SiC ingot is output. Since the correlation between the X-ray topographic image and the basal plane dislocation density is learned through deep learning, the evaluation device can estimate the basal plane dislocation density of a predetermined plane of the SiC ingot to be evaluated with high accuracy.

As described above, the output value (estimation value) output based on the X-ray topographic image is regarded as an output value of the basal plane dislocation density, using the correspondence table make in the preliminary step or the results learned in the preliminary step.

A value of a basal plane dislocation density to be assigned to the SiC ingot 10 may be an output value from a measurement value of the Si-face 1, may be an output value from a measurement value of the C-face 2, may be an output value from a measurement value of the side-face 3, may be an output value from measurement values of the Si-face 1 and the C-face 2, may be an output value from measurement values of the Si-face 1 and the side-face 3, or may be an output value from measurement values of all of the Si-face 1, the C-face 2, and the side-face 3. A value of a basal plane dislocation density to be assigned to the SiC ingot 10 preferably contains, for example, an output value of a measurement value of the side-face 3 or a measurement value of the side-face 3 and a measurement value of a plane other than the side-face 3. The value of the side-face 3 contains information on the thickness direction of the SiC ingot 10. It is difficult to obtain information on the thickness direction of SiC ingot 10 non-destructively, and the value of the basal plane dislocation density of the side-face 3 containing a part of information on the thickness direction is important information in processing of subsequent steps. If the variation in a basal plane dislocation density in the lengthwise direction of the ingot (the thickness direction of the SiC ingot 10) is large, measurement of only the Si-face or the C-face cannot reflect the quality of interior of the ingot. In this case, the side-face 3 can be used as a measurement target to measure a basal plane dislocation density of a location away from the Si-face or the C-face in the lengthwise direction of the ingot. In addition, a plurality of locations may be measured across the Z-direction. By doing so, the distribution information on the lengthwise direction of the basal plane in the ingot can be reflected in a value.

In addition, a value of a basal plane dislocation density to be assigned to the SiC ingot 10 is, for example, preferably an output value from a measurement value of the entire plane of at least one of the Si-face 1 and the C-face 2. Basal plane dislocations are often inherited in the stacking direction. Therefore, the data on the entire in-plane surface of the Si-face 1 or the C-face 2 is regarded as important information to understand information on the in-plane direction of the SiC ingot 10. For example, by checking the data on the entire in-plane surface of the Si-face 1 or the C-face 2, the position of areas where basal plane dislocations are concentrated can be ascertained.

As described above, to the SiC ingot according to the present embodiment, the value of the basal plane dislocation density (data) obtained from direct measurement results of the SiC ingot itself is assigned. Since the SiC ingot itself is evaluated, the SiC ingot according to the present embodiment has a high accuracy of quality assurance. In addition, since the SiC ingot itself is evaluated non-destructively, it is unnecessary to cut evaluation substrates from the SiC ingot. In other words, the SiC ingot according to the present embodiment has high yield at which products can be obtained from the SiC ingot.

In addition, according to the method of the present embodiment, the macroscopic X-ray topographic image of the SiC ingot can be used to estimate a basal plane dislocation density of the SiC ingot when determining a value of the SiC ingot. Classifying individual defects to determine the basal plane dislocation densities requires classification of individual defects, and it takes time to measure the basal plane dislocation densities. In contrast, when the SiC ingot is evaluated through this method, a basal plane dislocation density of a SiC substrate can be determined from the entire image, thereby reducing the time required to evaluate the basal plane dislocation density.

In addition, the X-ray topographic image of the SiC ingot also contains information on defects and strain in the SiC ingot. By performing the preliminary step using the X-ray topographic image containing both microscopic information on defects in the SiC ingot and macroscopic information on strain in the SiC ingot, the accuracy of estimating a basal plane dislocation density can be improved.

In addition, image compression when determining a basal plane dislocation density of the SiC ingot can reduce computational loads when estimating the basal plane dislocation density. When trying to accurately estimate the basal plane dislocation density, it is common to try to increase the resolution of images, but the basal plane dislocation density can be estimated with high accuracy even if the resolution of images is reduced in the present embodiment.

In addition, by defining the pixel size of the images during image compression, a basal plane dislocation density of a SiC ingot to be evaluated can be estimated even if the diameters of the SiC ingots used for measurement in the preliminary step are different from that of the SiC ingot to be evaluated. For example, it is difficult to manufacture SiC ingots with a diameter of 8 inches or larger, and it is difficult to prepare many samples in the preliminary step. Even in this case, the preliminary step can be performed on a SiC ingot with a diameter of 6 inches, and a basal plane dislocation density of an 8-inch SiC ingot can be estimated based on the correspondence table or learning results on a 6-inch SiC ingot.

"Method for manufacturing SiC ingot"

A method for manufacturing a SiC ingot according to the present embodiment includes a crystal growth step, a cylinder processing step, a measurement step, and an evaluation step.

In the crystal growth step, SiC is grown on one plane of a seed crystal. The crystal growth step can be performed through a well-known method, and for example, a sublimation method can be used.

In the cylinder processing step, a SiC single crystal (SiC boule) after crystal growth is processed into a cylinder shape. It is preferable that, after cylinder processing, the Si-face 1, the C-face 2, or the side-face 3 be mirror-polished, mechanically polished, or polished by CMP. It is preferable that, planes such as the Si-face 1, the C-face 2, and the side-face 3 to be measured in the measurement step be at least mirror-polished, mechanically polished, or polished by CMP.

In the measurement step and the evaluation step, a basal plane dislocation density of a measurement plane of the SiC ingot 10 is determined. The above-described methods can be used in the measurement step and the evaluation step. In the measurement step, at least one of the Si-face 1, the C-face 2, and the side-face 3 of the SiC ingot 10 is directly measured. In the measurement step, for example, an X-ray topographic image is measured. In the measurement step, for example, at least one of the Si-face 1 and the C-face 2 may be measured, at least the side-face 3 may be measured, the Si-face 1 and the C-face 2 may be measured, the Si-face 1 or the C-face 2 and the side-face 3 may be measured, and the Si-face 1, the C-face 2, and the side-face 3 may be measured.

In the evaluation step, a basal plane dislocation density of a SiC ingot is obtained based on measurement results in the measurement step. A basal plane dislocation density of a SiC ingot is estimated from the measurement results in the measurement step using the correspondence table or the learning results obtained in the preliminary step.

The method for manufacturing a SiC ingot according to the present embodiment also includes a step for quality assurance of a SiC ingot. Therefore, the quality of a SiC ingot prepared through the method for manufacturing a SiC ingot according to the present embodiment is guaranteed. In addition, in the method for manufacturing a SiC ingot according to the present embodiment, since quality assurance can be performed non-destructively, the SiC ingot yield can be increased.

Although the preferred embodiment of the present disclosure has been described in detail above, the present disclosure is not limited to a specific embodiment and various modifications and changes can be made within the scope of the gist of the present disclosure disclosed in the claims.

### EXPLANATION OF REFERENCES

1 Si-face
2 C-face
3 Side-face
10 SiC Ingot
11 Support
12 Driving mechanism
13 Measurement mechanism

## Claims

1. A SiC ingot,
wherein a value of a basal plane dislocation density obtained by directly measuring at least one of a Si-face, a C-face, and a side-face has been identified.

2. The SiC ingot according to claim 1,
wherein the value of the basal plane dislocation density is an output value determined from entire-plane measurement results of at least one of the Si-face and the C-face.

3. The SiC ingot according to claim 1,
wherein the value of the basal plane dislocation density is an output value determined from a measurement value of the side-face or a measurement value of the side-face and a measurement value of a plane other than the side-face.

4. The SiC ingot according to any one of claims 1 to 3,
wherein the value of the basal plane dislocation density is a value determined from a correspondence table which is obtained through a preliminary study and represents a correlation between the basal plane dislocation density and a reflection X-ray topographic image of at least one of the Si-face, the C-face, and the side-face.

5. The SiC ingot according to any one of claims 1 to 3,
wherein the value of the basal plane dislocation density is an estimation value estimated from a reflection X-ray topographic image of at least one of the Si-face, the C-face, and the side-face based on learning results of deep learning.

6. A method for manufacturing a SiC ingot, comprising:
a measurement step of directly measuring at least one of a Si-face, a C-face, and a side-face of a SiC ingot; and
an evaluation step of determining a basal plane dislocation density of the SiC ingot based on a correlation between measurement results of the measurement step and the basal plane dislocation density.

7. The method for manufacturing a SiC ingot according to claim 6,
wherein, in the measurement step, at least one of the Si-face and the C-face is measured.

8. The method for manufacturing a SiC ingot according to claim 6 or 7,
wherein, in the measurement step, at least the side-face is measured.

9. The method for manufacturing a SiC ingot according to any one of claims 6 to 8,
wherein, in the measurement step, a reflection X-ray topographic image is measured.

10. The method for manufacturing a SiC ingot according to any one of claims 6 to 9,
wherein, in the evaluation step, the basal plane dislocation density of the SiC ingot is estimated based on learning results of deep learning.
